# EUROPEAN PATENT APPLICATION

(11) **EP 2 541 761 A1**
(43) Date of publication of application: **02.01.2013**
(21) Application number: 11832077.9
(22) Date of filing: 27.10.2011
(51) Int. Cl.: H03F 1/07

(54) **DOHERTY POWER AMPLIFIER APPARATUS AND POWER AMPLIFICATION METHOD**

(30) Priority: 29.04.2011 CN 201110110872
(71) Applicant: ZTE Corporation, Shenzhen city, Guangdong 518057 (CN)
(72) Inventor: DUAN, Bin, Shenzhen City, Guangdong Province 518057 (CN); CUI, Xiaojun, Shenzhen City, Guangdong Province 518057 (CN); CHEN, Huazhang, Shenzhen City, Guangdong Province 518057 (CN); LIU, Jianli, Shenzhen City, Guangdong Province 518057 (CN)
(74) Representative: Novagraaf Technologies
(86) International application number: PCT/CN2011/081418
(87) International publication number: WO 2012/146010

(57) **Abstract**

A Doherty power amplifier apparatus and power amplification method are disclosed in the present invention. The apparatus includes a main power amplifier apparatus and an auxiliary power amplifier apparatus, and the main power amplifier apparatus is configured to adopt a High Voltage Heterojunction Bipolar Transistor (HVHBT) device to amplify signal power, and the auxiliary power amplifier apparatus is configured to adopt a High Electron Mobility Transistor (HEMT) device to amplify signal power. A power amplification efficiency of a whole Doherty power amplifier will be enhanced substantially according to the present invention.

## Description

### Technical Field

The present invention relates to the technology field of radio frequency power amplifier design, and particularly to a Doherty power amplifier apparatus and a power amplification method.

### Background of the Related Art

Faced with increasingly fierce competition in the market, efficiency of base station products become an important reference point for competition in the industry, and an enhancement of efficiency of a main component which decides the efficiency as a power amplifier device also becomes a core point, and a lot of human and material resource in the industry is invested in the research of efficiency enhancement technology, and at present, the most widely used technology comprises the Doherty technology, and power amplifier manufacturers have begun mass production and application of the Doherty power amplifiers, thereby how to further improve the efficiency of the technology is particularly important.

The Doherty technology is originally applied in a traveling-wave tube, to provide a high-power transmitter for broadcast, with a simple, easy-to-implement and high efficient architecture.

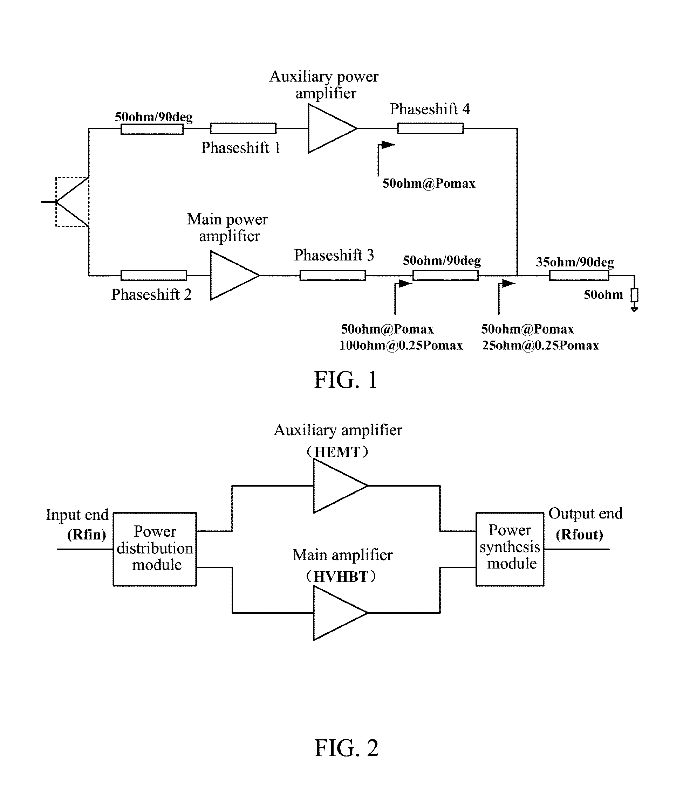

A traditional Doherty structure is composed of two power amplifiers: a main power amplifier (also called as carrier power amplifier), an auxiliary power amplifier (also called as peak power amplifier), wherein the main power amplifier works in class B or class AB, and the auxiliary power amplifier works in class C. The two power amplifiers do not work by turns, in fact the main power amplifier works all the time while the auxiliary power amplifier works at a set peak value (therefore the auxiliary power amplifier is also called as a peak power amplifier). A quarter wavelength line at 90 degrees behind the output end of the main power amplifier plays the role of impedance transformation, whose purpose is to play the role of reducing apparent impedance of the main power amplifier when the auxiliary power amplifier works, thereby ensuring that an active load impedance composed of the main power amplifier and a subsequent circuit becomes lower when the auxiliary power amplifier works, and thus output current of the main power amplifier becomes higher. Because of a quarter wavelength line behind the output end of the main power amplifier, a 90° phase shift is also required in front of the auxiliary power amplifier, in order to make outputs of the two power amplifiers in same phase, as shown in FIG. 1.

The main power amplifier works in class B, and when a total input signal is relatively small, only the main power amplifier is in a working state; when an output voltage of the main power amplifier tube reaches a peak saturation point, the theoretical efficiency of power amplifier can reach 78.5%. If excitation doubles here, then the saturation will appear when the main power amplifier tube reaches half of the peak value, and the efficiency of the power amplifier also reaches a maximum of 78.5%, and now the auxiliary power amplifier also begins to work together with the main power amplifier. An introduction of the auxiliary power amplifier makes the load decrease from the point of view of the main power amplifier, because the function of the auxiliary power amplifier for the load is equivalent to negative impedance in series, so even though the output voltage of the main power amplifier is saturated and constant, the output power continues to increase because of the decreasing load (current flowing through the load increases). When a peak value of the excitation is reached, the auxiliary power amplifier reaches a maximum point of its own efficiency, such that a combination efficiency of the two power amplifiers is much higher than the efficiency of a single power amplifier of class B. The maximum efficiency 78.5% of a single power amplifier of class B appears at the peak value while now the efficiency 78.5% appears at half of the peak value, so such system structure can bring a higher efficiency (each amplifier can reach the maximum output efficiency).

Both of the main power amplifier and the peak power amplifier (auxiliary power amplifier) of the Doherty amplifier adopt the same type of power amplifier tube, and what is the most common in the industry is a Laterally Diffused Metal Oxide Semiconductor (LDMOS for short) device. By adopting the same type of power amplifier tube, supply voltages and biasing mode thereof are the same, so that a biasing circuit is easy to be designed; a mass production of the power amplifier tubes is relatively easy to be controlled due to the same type. Mainstream LDMOS devices in the industry have developed to the 8th generation with a low cost, however, the room of improvement of performance is very limited, which can not satisfy the requirements of environment protection meanwhile.

### Summary of the Invention

The technical problem to be solved by the present invention is to provide a Doherty power amplifier apparatus and a power amplification method, to enhance the power amplification efficiency of the Doherty power amplifier apparatus.

In order to solve the above technical problem, the present invention provides a Doherty power amplifier apparatus, comprising a main power amplifier apparatus and an auxiliary power amplifier apparatus, wherein,
the main power amplifier apparatus is configured to use a High Voltage Heterojunction Bipolar Transistor (HVHBT) device to amplify signal power; the auxiliary power amplifier apparatus is configured to use a High Electron Mobility Transistor (HEMT) device to amplify signal power.

The above Doherty power amplifier apparatus may also have the following characteristic:
the HEMT device is a GaN-based device.

The above Doherty power amplifier apparatus may also have the following characteristic:
the HVHBT device is a GaAs-based device.

The present invention also provides a power amplification method, comprising:
in a Doherty power amplifier apparatus, using a High Electron Mobility Transistor (HEMT) device and a High Voltage Heterojunction Bipolar Transistor (HVHBT) device to amplify signal power.

The above method may also have the following characteristic of:
using a High Voltage Heterojunction Bipolar Transistor (HVHBT) device to amplify signal power of the main power amplifier apparatus and using a High Electron Mobility Transistor
(HEMT) device to amplify signal power of the auxiliary power amplifier apparatus.

The above method may also have the following characteristic:
the HEMT device is a GaN-based device.

The above method may also have the following characteristic:
the HVHBT device is a GaAs-based device.

The above method may also have the following characteristic of:
selecting the HEMT device according to power amplification parameters of the Doherty power amplifier apparatus.

The above method may also have the following characteristic of:
selecting the HVHBT device according to power amplification parameters of the Doherty power amplifier apparatus.

Compared with an existing Doherty power amplifier in which both a main power amplifier and an auxiliary power amplifier use LDMOS, a power amplification efficiency of the whole Doherty power amplifier may increase substantially by use of the above schemes.

In addition, since there are currently few types of HVHBT products (only 1-2 types), diversified power level requirements for base station products can not be realized; due to a relatively mature development of GaN products, there are a variety of products in each manufacturers, so GaN products with different model numbers can be used as peak amplifiers according to different power levels in application, in flexible combination with a main amplifier adopting a HVHBT power amplifier tube, and it may be implemented by adopting different Doherty structures (symmetrical structure, asymmetrical structure, multichannel structure and so on) as required, which thus ensures optimal performance and ensures ease of use and flexibility.

### Brief Description of Drawings

FIG. 1 is a structural diagram of a traditional Doherty power amplifier;
FIG. 2 is a structural diagram of a Doherty power amplifier with a two-channel structure according to an embodiment;
FIG. 3 is a structural diagram of a Doherty power amplifier with a multichannel structure according to an embodiment.

### Preferred Embodiments of the Present Invention

A Doherty power amplifier apparatus in the embodiment of the present invention comprises an auxiliary power amplifier apparatus and a main power amplifier apparatus.

The auxiliary power amplifier apparatus is configured to adopt a High Electron Mobility Transistor (called as HEMT for short) device to amplify signal power.

The HEMT device is a GaN-based device.

Wherein, the main power amplifier apparatus is configured to adopt a High Voltage Heterojunction Bipolar Transistor (called as HVHBT for short) device to amplify signal power. The HVHBT device refers to a HBT technology device that can works under a high voltage, and the high voltage refers to a working voltage over 12V. It includes, but not limited to, a Tripower series of power amplifier devices in Triquint Company of America.

The HVHBT device may be a GaAs-based device.

A corresponding power amplification method comprises: in a Doherty power amplifier apparatus, adopting a HEMT device and a HVHBT device to amplify signal power.

In the method, it is specifically that a HVHBT device is adopted to amplify signal power of a main power amplifier apparatus, and the HEMT device is adopted to amplify signal power of an auxiliary power amplifier apparatus.

The HEMT device is a GaN-based device, and the HVHBT device is a GaAs-based device.

The HEMT device is selected according to power amplification parameters of the Doherty power amplifier apparatus. The HVHBT device is selected according to power amplification parameters of the Doherty power amplifier apparatus. The power amplification parameters of the Doherty power amplifier apparatus comprise: working frequency, power value and peak-to-average ratio.

As shown in FIG. 2, for a two-channel Doherty power amplifier (including a traditional symmetrical Doherty structure and asymmetrical Doherty structure with two channels) and a structure including a main amplifier and an auxiliary amplifier evolved on the basis of the two-channel Doherty power amplifier, a HVHBT power amplifier tube works as a main amplifier, and a HEMT power amplifier tube works as an auxiliary amplifier.

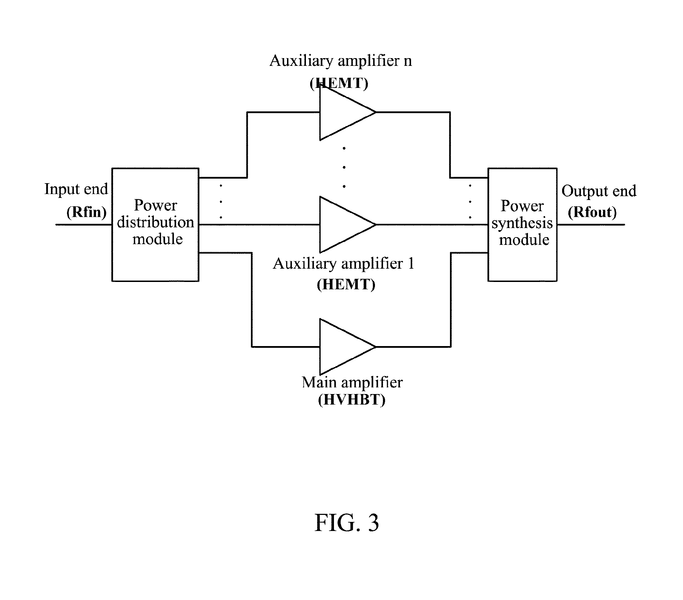

As shown in FIG. 3, for a multichannel Doherty power amplifier and a structure including a main amplifier and multiple auxiliary amplifiers evolved on the basis of the multichannel Doherty power amplifier, a HVHBT power amplifier tube works as a main power amplifier, and a HEMT power amplifier tube works as an auxiliary amplifier.

In the design of a Doherty power amplifier, the model number of HVHBT power amplifier tube used by a main amplifier is determined according to required power amplification parameters; the structure of Doherty power amplifier is determined (two-channel structure or multichannel structure), and the model number of HEMT power amplifier tube used by an auxiliary amplifier is determined; the matching design of the amplifiers and the design of parts of power distribution and power synthesis in a block diagram are completed; and the design of remaining parts of the Doherty power amplifier is completed.

A Doherty power amplifier apparatus applicable to embodiments of the present invention comprises a power distribution module and a power synthesis module, wherein the power distribution module is responsible for the function of distributing input signals to a main power amplifier and an auxiliary power amplifier respectively, and regarding to a traditional Doherty power amplifier as shown in FIG. 1, the power distribution module comprises a component part between input ends of auxiliary power amplifier and main power amplifier and an input end (RFin) of a whole Doherty power amplifier. The power synthesis module is responsible for the function of combining an amplified signal output by the main power amplifier and an amplified signal of the auxiliary power amplifier, and regarding to a traditional Doherty power amplifier as shown in FIG. 1, the power synthesis module comprises a component part between output ends of auxiliary power amplifier and main power amplifier and an output end (RFout) of a whole Doherty power amplifier. The power distribution module and the power synthesis module are not limited to the structure of the traditional Doherty power amplifier as shown in FIG. 1, and they respectively correspond to a circuit layout that executes the corresponding power distribution function and a circuit layout that executes the corresponding power synthesis function in a Doherty power amplifier with other structure applicable to embodiments of the present invention.

### Specific application examples:

For the Doherty power amplifier design with power of 55W and a peak-to-average ratio of 6dB applied in the 2.1 GHz UMTS system, two power amplifier tubes with saturation power of totaling at least 200W are required. In combination with existing devices of power amplifier tube manufacturers, it may be implemented by using two LDMOS power amplifier tubes with power of 120W respectively through a symmetrical Doherty structure, and the single and final power amplification efficiency thereof is about 52% according to a current level of device in the industry. And in the implementation of method according to embodiments of the present invention, a main amplifier uses a HVHBT power amplifier tube with power of 120W based on GaAs, and an auxiliary amplifier uses a HEMT power amplifier tube with power of 120W based on GaN, and the single and final power amplification efficiency thereof is about 58%, enhancing the power amplification efficiency.

A breakthrough and new combination mode is adopted in embodiments of the present invention, making full use of advantage of high efficiency of a HVHBT power amplifier tube which works as a main amplifier to enhance the efficiency and realize an optimal performance; meanwhile by way of making use of advantages of higher efficiency and complete device types of HEMT power amplifier tube, the HEMT power amplifier tube works as an auxiliary amplifier to realize an optimal performance.

It should be noted that, in the case without conflicts, embodiments and characteristics in the embodiments of the application can be combined with each other at random.

Of course, there may be many other embodiments of the present invention, and those skilled in the art may make various corresponding changes and variations according to the present invention without departing from the spirit and essence of the present invention, and these corresponding changes and variations should fall into the protection scope of appended claims of the present invention.

Those ordinary people skilled in the art should understand that all or part of steps of the above-mentioned method may be completed by program instructing relevant hardware, the program may be stored in a computer readable storage medium such as a read only memory, a magnetic disk or a compact disk and so on. Alternatively, all or part of steps of the above-mentioned embodiments may also be implemented by using one or more integrated circuits. Correspondingly, each module/unit in the above-mentioned embodiments may be implemented in form of hardware, or may be implemented in form of software function module. The present invention is not limited to any specified form of the combination of hardware and software.

### Industrial Applicability

Compared with an existing Doherty power amplifier in which both a main power amplifier and an auxiliary power amplifier use LDMOS, the power amplification efficiency of the whole Doherty power amplifier may be enhanced substantially according to the above embodiments, which ensures the optimal performance and ensures ease of use and flexibility.

## Claims

1. A Doherty power amplifier apparatus, comprising a main power amplifier apparatus and an auxiliary power amplifier apparatus, wherein,
the main power amplifier apparatus is configured to adopt a High Voltage Heterojunction Bipolar Transistor (HVHBT) device to amplify signal power; the auxiliary power amplifier apparatus is configured to adopt a High Electron Mobility Transistor (HEMT) device to amplify signal power.

2. The Doherty power amplifier apparatus according to claim 1, wherein,
the HEMT device is a GaN-based device.

3. The Doherty power amplifier apparatus according to claim 2, wherein,
the HVHBT device is a GaAs-based device.

4. A power amplification method, comprising:
in a Doherty power amplifier apparatus, adopting a High Electron Mobility Transistor (HEMT) device and a High Voltage Heterojunction Bipolar Transistor (HVHBT) device to amplify signal power.

5. The method according to claim4, further comprising:
adopting the High Voltage Heterojunction Bipolar Transistor (HVHBT) device to amplify signal power of main power amplifier apparatus and adopting the High Electron Mobility Transistor (HEMT) device to amplify signal power of auxiliary power amplifier apparatus.

6. The method according to claim 4 or 5, wherein,
the HEMT device is a GaN-based device.

7. The method according to claim 6, wherein,
the HVHBT device is a GaAs-based device.

8. The method according to claim 5, further comprising:
selecting the HEMT device according to power amplification parameters of the Doherty power amplifier apparatus.

9. The method according to claim 6, further comprising:
selecting the HVHBT device according to power amplification parameters of the Doherty power amplifier apparatus.
